# EUROPEAN PATENT SPECIFICATION

(11) **EP 3 460 934 B1**
(45) Date of publication and mention of the grant of the patent: **22.12.2021**
(21) Application number: 16902348.8
(22) Date of filing: 17.05.2016
(51) Int. Cl.: H02H 3/347, H01H 83/04

(54) **EARTH LEAKAGE CIRCUIT BREAKER**
ERDSCHLUSSSCHUTZSCHALTER
INTERRUPTEUR DE DÉFAUT À LA MASSE

(43) Date of publication of application: 27.03.2019
(73) Proprietor: Mitsubishi Electric Corporation, Chiyoda-ku Tokyo 100-8310 (JP)
(72) Inventor: OHASHI Hiroaki, Tokyo 100-8310 (JP); ITAKURA Takeshi, Tokyo 100-8310 (JP)
(74) Representative: Diehl & Partner
(86) International application number: PCT/JP2016/064578
(87) International publication number: WO 2017/199328

(56) References cited:
- EP-A2- 1 793 466
- EP-A2- 2 211 437
- JP-A- 2007 285 790
- JP-A- 2010 170 902
- JP-A- 2014 010 077
- US-A- 4 307 429

## Description

### [Technical Field]

This invention relates to a ground fault interrupter that outputs electric leakage test signals from two ports of a built-in IC or microcontroller and can change the duty ratios and phases of the electric leakage test signals.

### [Background Art]

In the past, as a ground fault interrupter, as a means for checking whether or not an operation which is performed when electric leakage is detected is sound, an electric leakage test function has been provided. As the ground fault interrupter provided with the electric leakage test function, there is a ground fault interrupter including a zero-phase current transformer that detects a leakage current, a sensing resistor that converts a secondary-side output current of the zero-phase current transformer into a voltage, a signal detection circuit that takes in the voltage generated in the sensing resistor by using A/D conversion, and an electric leakage test circuit that outputs an electric leakage test signal to a tertiary winding of the zero-phase current transformer, the ground fault interrupter configured so that, by applying the electric leakage test signal to the tertiary winding of the zero-phase current transformer from the electric leakage test circuit, the signal detection circuit detects the secondary-side output current of the zero-phase current transformer in accordance with the electric leakage test signal and interrupts an electric circuit in accordance with the electric leakage characteristics or outputs an electric leakage alarm warning.

Moreover, in, for example, JP-A-9-219923 (PTL 1), JP-UM-A-6-84380 (PTL 2), and JP-A-2014-11909 (PTL 3), interrupters that have the function of interrupting a current by detecting an electric leakage or a ground fault and can conduct an electric leakage test or a ground fault test are disclosed.

### [Citation List]

### [Patent Literature]

[PTL 1] JP-A-9-219923
[PTL 2] JP-UM-A-6-84380
[PTL 3] JP-A-2014-11909

EP2211437, against which the preamble is based on, provides a ground fault interrupter comprising a zero-phase current transformer for detecting a leakage current flowing through alternating-current electric circuits;a sensing resistor; a signal detection circuit that outputs a tripping signal or an alarm signal if a detected voltage is greater than or equal to a given voltage; an electric leakage test circuit that outputs one single electric leakage test signals having different phases.

US 4,307,429 discloses an apparatus for monitoring conductor currents for a fault current which changes the magnetic bias of a magnetic circuit. The apparatus has a secondary winding to which a capacitor and a tripping device are connected, by an electronic circuit shunted across the secondary winding and the capacitor. The electronic circuit includes a pulse generator coupled to deliver to the secondary winding sequences of magnetizing pulses of predetermined number and with a direction which changes after each sequence, an evaluation device coupled to detect the respective number of pulses within the pulse sequences up to which the pulse amplitude exceeds a predetermined voltage reference value at a predetermined sampling point within the pulse, means to derive an output signal from the change of said number of pulses and means for controlling said pulse generator, evaluation device and means to derive.

### [Summary of Invention]

### [Technical Problem]

Since the existing ground fault interrupter described in the documents of the above citation list is a ground fault interrupter that makes one port of a built-in IC or microcontroller output an electric leakage test signal, the ground fault interrupter can only imitate a simple rectangular waveform.

Moreover, when a test signal is imitated by a port output, while a normal leakage current waveform is an alternating-current waveform, the test signal is a simple rectangular waveform; therefore, the existing ground fault interrupter is insufficient because it cannot imitate an alternating-current waveform as a simulated waveform.

Furthermore, since one port of the built-in IC or microcontroller is made to output an electric leakage test signal, only an output in accordance with the output capacity of the port can be output, which makes it necessary to attach a buffer circuit or the like externally if necessary.

This invention has been made to solve the above-described problems of the existing ground fault interrupter, and an object thereof is to obtain a ground fault interrupter that can output a simulated waveform close to an alternating-current waveform and can also imitate a special waveform such as a thyristor load waveform.

### [Solution to Problem]

The above object is solved by the combination of features of independent claim 1. Preferred embodiments are defined in the dependent claims.

A ground fault interrupter includes: a zero phase current transformer that detects a leakage current flowing through alternating-current electric circuits; a sensing resistor that converts a secondary-side output current of the zero-phase current transformer into a voltage; a signal detection circuit that takes in the voltage generated in the sensing resistor by performing A/D conversion and outputs a tripping signal or an alarm signal if the detected voltage taken in by the A/D conversion is greater than or equal to a given voltage; an electric leakage test circuit that outputs two or more electric leakage test signals having different phases; an alarm output circuit that operates by receiving the tripping signal or the alarm output signal; and a trigger circuit that outputs the electric leakage test signals.

### [Advantageous Effects of Invention]

Since a ground fault interrupter according to this invention includes a zero-phase current transformer for detecting a leakage current flowing through alternating-current electric circuits, a sensing resistor that converts a secondary-side output current of the zero-phase current transformer into a voltage, a signal detection circuit that takes in the voltage generated in the sensing resistor by performing A/D conversion and outputs a tripping signal or an alarm signal if a detected voltage is greater than or equal to a given voltage, an electric leakage test circuit that outputs two or more electric leakage test signals having different phases, an alarm output circuit that operates by receiving the tripping signal or the alarm output signal, and a trigger circuit that outputs the electric leakage test signals, the ground fault interrupter can output, in a simplified manner, an electric leakage test signal which is used in a test operation, a waveform close to an actual waveform, not a simple rectangular waveform, which makes it possible to, even when a waveform whose phase is indeterminate, such as a waveform flowing through a thyristor circuit, for example, is input, perform a check as to whether the ground fault interrupter operates normally by outputting a simulated signal waveform from the electric leakage test circuit.

The other objects, features, aspects, and effects of this invention will become more apparent from the following detailed description of this invention with reference to the drawings.

### [Brief Description of Drawings]

[Fig. 1] Fig. 1 is a block diagram depicting a ground fault interrupter according to Embodiment 1 of this invention.
[Fig. 2] Fig. 2 is a circuit diagram depicting the outline of an electric leakage test circuit of the ground fault interrupter according to Embodiment 1 of this invention.
[Fig. 3] Fig. 3 is a chart diagram showing a first simulated waveform pattern which is output from the electric leakage test circuit of the ground fault interrupter according to Embodiment 1 of this invention.
[Fig. 4] Fig. 4 is a diagram explaining the details of the electric leakage test circuit of the ground fault interrupter according to Embodiment 1 of this invention.
[Fig. 5] Fig. 5 is a chart diagram showing a second simulated waveform pattern which is output from the electric leakage test circuit of the ground fault interrupter according to Embodiment 1 of this invention.
[Fig. 6] Fig. 6 is a chart diagram showing a third simulated waveform pattern which is output from the electric leakage test circuit of the ground fault interrupter according to Embodiment 1 of this invention.
[Fig. 7] Fig. 7 is a block diagram depicting a ground fault interrupter according to Embodiment 2 of this invention.

### [Description of Embodiments]

Hereinafter, preferred embodiments of a ground fault interrupter according to this invention will be described in detail with reference to the drawings.

### Embodiment 1.

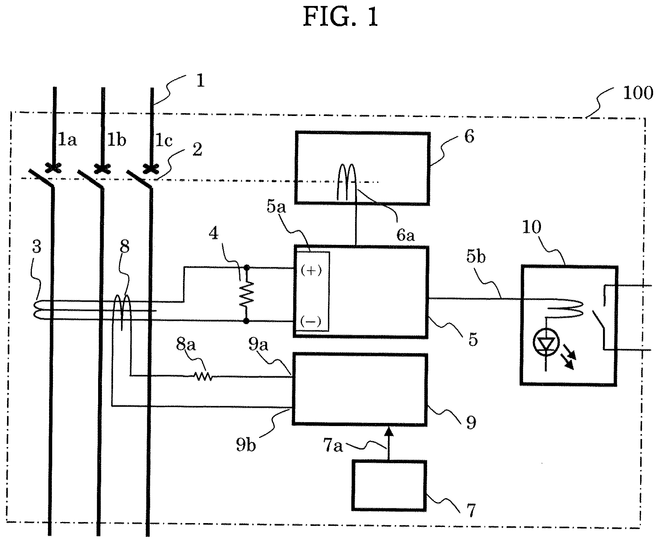

Fig. 1 is a block diagram depicting a ground fault interrupter according to Embodiment 1 of this invention.

In Fig. 1, a ground fault interrupter 100 includes switching contacts 2 that individually open and close alternating-current electric circuits 1 including a first-phase alternating-current electric circuit 1a, a second-phase alternating-current electric circuit 1b, and a third-phase alternating-current electric circuit 1c which are unit electric circuits, a zero-phase current transformer 3 that is inserted into the alternating-current electric circuits 1 and outputs a current signal proportional to a leakage current flowing through the alternating-current electric circuits 1, a sensing resistor 4 that converts the current signal generated by the zero-phase current transformer 3 into a voltage signal proportional to this current signal, a signal detection circuit 5 that takes in the voltage signal of the sensing resistor 4 as digital data by an A/D converter circuit 5a having a differential input function and detects an electric leakage, a tripping circuit 6 that has a tripping coil 6a, which is energized by an output signal of the signal detection circuit 5 if the detected voltage of the signal detection circuit 5 exceeds a prescribed leakage current value and is greater than or equal to a given voltage, and drives the switching contacts 2 to open at the time of energization of this tripping coil 6a, a trigger circuit 7 that outputs a trigger signal 7a used to check whether the ground fault interrupter 100 operates normally when a leakage current flows in a state where a leakage current does not flow through the alternating-current electric circuits 1, and an electric leakage test circuit 9 that passes a current through a tertiary winding 8 of the zero-phase current transformer 3 based on the trigger signal from the trigger circuit 7.

Moreover, the ground fault interrupter 100 includes an alarm output circuit 10 that performs display by a contact output or an LED by being operated by the output of an alarm signal 5b from the signal detection circuit 5.

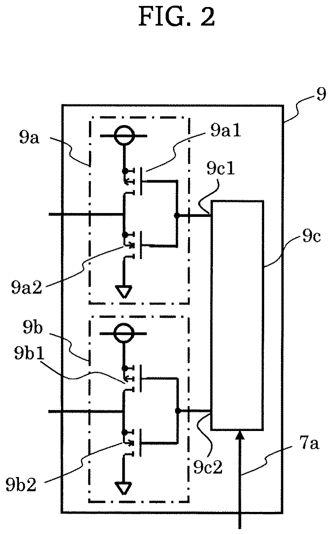

The electric leakage test circuit 9 is configured with a first port 9a, a second port 9b, and a control section 9c as depicted in Fig. 2.

The first port 9a is configured with a first FET 9a1, which is a p-type field-effect transistor, whose drain is connected to a power supply and a second FET 9a2, which is an n-type field-effect transistor, whose drain is connected to the source of the first FET 9a1 and whose source is connected to a ground. Moreover, the gate of the first FET 9a1 and the gate of the second FET 9a2 are connected and a node thereof is connected to the control section 9c.

Likewise, as depicted in Fig. 2, the second port 9b of the electric leakage test circuit 9 is configured with a third FET 9b1, which is a p-type field-effect transistor, whose drain is connected to the power supply and a fourth FET 9b2, which is an n-type field-effect transistor, whose drain is connected to the source of the third FET 9b1 and whose source is connected to the ground. Moreover, the gate of the third FET 9b1 and the gate of the fourth FET 9b2 are connected and a node thereof is connected to the control section 9c. The trigger signal 7a from the trigger circuit 7 is also input to the control section 9c. It is to be noted that, in Fig. 2, a reference sign 9c1 denotes a first output of the control section 9c and a reference sign 9c2 denotes a second output of the control section 9c.

Then, as depicted in Fig. 1, a node between the source of the first FET 9a1 and the drain of the second FET 9a2 is connected to one end of the tertiary winding 8 of the zero-phase current transformer 9, and a node between the source of the third FET 9b1 and the drain of the fourth FET 9b2 is connected to the other end of the tertiary winding 8. Moreover, in the tertiary winding 8, a resistor 8a for defining the current flowing through the tertiary winding 8 is provided.

The ground fault interrupter according to Embodiment 1 is configured as described above; next, an electric leakage test will be described.

The electric leakage test is a test that checks, by passing a pseudo leakage current through the test winding 8 in a state where a leakage current does not flow through the alternating-current electric circuits 1, whether an electric current interrupting operation is performed when a leakage current flows as a function of checking whether or not the ground fault interrupter 100 operates normally at the time of generation of a leakage current.

Next, a detailed operation of the electric leakage test will be described.

By making the electric leakage test circuit 9 output a simulated waveform of a leakage current by inputting the trigger signal 7a to the control section 9c of the electric leakage test circuit 9 from the trigger circuit 7, the A/D converter circuit 5a of the signal detection circuit 5 detects the simulated waveform of the leakage current. The simulated waveform of the leakage current is assumed to be a waveform exceeding a previously prescribed leakage current value. The signal detection circuit 5 that has detected the simulated waveform of the leakage current operates the tripping circuit 6 by outputting the tripping signal to the tripping coil 6a and interrupts the alternating-current electric circuits 1 by opening the switching contacts 2. In addition thereto, the signal detection circuit 5 operates the alarm output circuit 10 by outputting the alarm signal 5b. As a result, it is possible to check the same operation as the operation which is performed at the time of generation of the leakage current in the alternating-current electric circuits 1.

A method for outputting a simulated waveform of a leakage current from the electric leakage test circuit 9 in the present embodiment is a configuration in which a pseudo leakage current is directly applied to the tertiary winding 8 of the zero-phase current transformer 3.

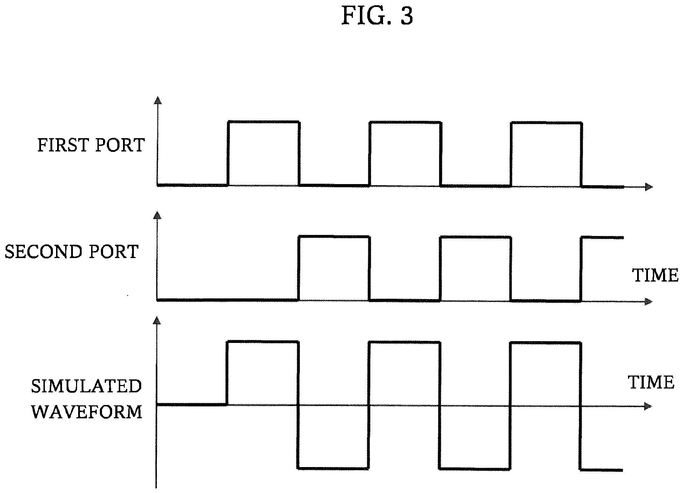

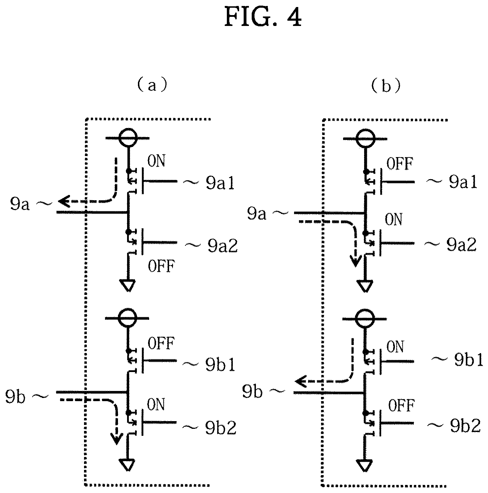

Fig. 3 is a chart diagram showing a first simulated waveform pattern which is output from the electric leakage test circuit 9. Moreover, Fig. 4 is a diagram explaining the details of the electric leakage test circuit 9; (a) depicts a state where the first port 9a outputs Hi and the second port 9b outputs Lo and (b) depicts a state where the first port 9a outputs Lo and the second port 9b outputs Hi.

As depicted in Fig. 3, by alternately driving the first port 9a and the second port 9b of the electric leakage test circuit 9 , an alternating-current waveform of rectangular waves is configured in a simulated manner, and a current with a pseudo waveform is passed through the tertiary winding 8.

More specifically, as depicted in Fig. 4(a), by making the first output 9c1 of the control section 9c become a Hi output and making the second output 9c2 of the control section 9c become a Lo output, the first port 9a becomes Hi and the second port 9b becomes Lo and a current flows through the tertiary winding 8 from the first port 9a to the second port 9b.

Next, as depicted in Fig. 4(b), by making the first output 9c1 of the control section 9c become a Lo output and making the second output 9c2 of the control section 9c become a Hi output, the first port 9a becomes Lo and the second port 9b becomes Hi and a current flows through the tertiary winding 8 from the second port 9b to the first port 9a.

Then, the secondary winding of the zero-phase current transformer 3 is excited by this current, and an exciting current proportional to the current passed through the tertiary winding 8 is generated. A voltage proportional to the current passed through the tertiary winding 8 is generated at the ends of the sensing resistor 4 by this exciting current and is taken in by the signal detection circuit 5 as digital data in the A/D converter circuit 5a of the signal detection circuit 5. Then, since the pseudo leakage current is set so as to have a waveform exceeding a prescribed current value, by operating the tripping circuit 6 by exciting the tripping coil 6a, the signal detection circuit 5 performs a test operation that interrupts the alternating-current electric circuits 1 by opening the switching contacts 2.

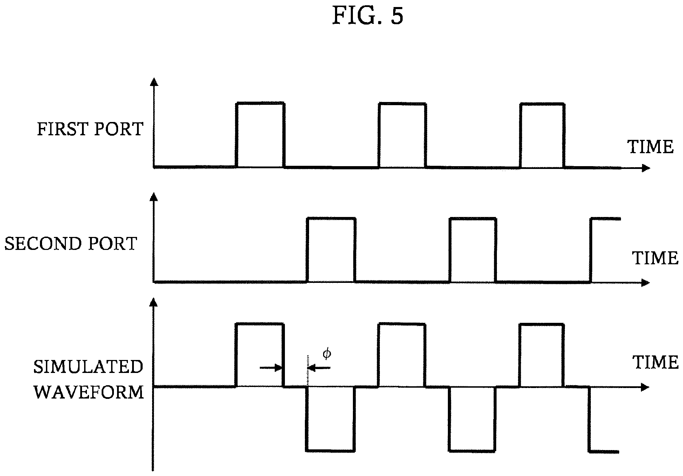

The A/D converter circuit 5a of the signal detection circuit 5 has a differential input function and can obtain a signal imitating an alternating-current waveform by making each of the first port 9a and the second port 9b of the electric leakage test circuit 9 output a signal. Fig. 5 is a chart diagram showing a second simulated waveform pattern which is output from the electric leakage test circuit 9, and illustrates an example in which a waveform that is more nearly sinusoidal is output. That is, by providing the outputs of the first port 9a and the second port 9b with a phase difference φ, it is possible to output a simulated waveform which is more nearly sinusoidal, not simple rectangular waves. Moreover, since it is possible to perform phase control arbitrarily from the ports, an operation check using a test waveform with a phase shift like a thyristor circuit, for example, is also possible, and it is possible to perform, by using a test signal, a check as to whether or not an interrupting operation is properly performed at the time of generation of a leakage current with a possible waveform. Moreover, each of the outputs of the first port 9a and the second port 9b may be changed to an arbitrary duty ratio, and, by performing waveform control of the outputs of the first port 9a and the second port 9b, it is possible to output, in a simplified manner, an electric leakage test signal which is used in a test operation, a waveform close to an actual waveform, not a simple rectangular waveform.

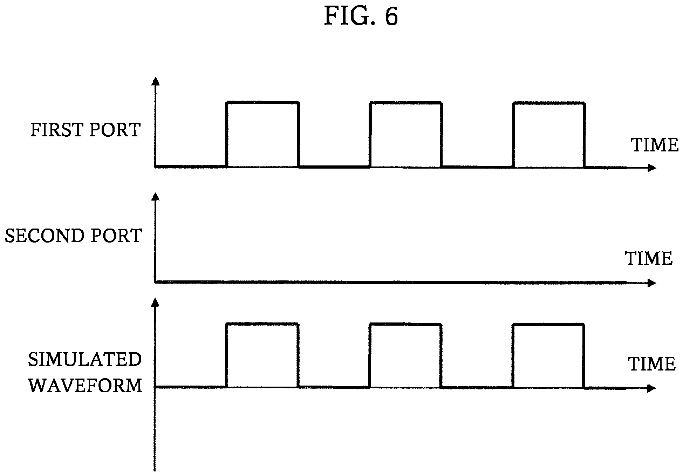

Moreover, Fig. 6 is a chart diagram showing a third simulated waveform pattern which is output from the electric leakage test circuit 9, and illustrates an example in which a waveform that imitates a ground-fault current subjected to half-wave rectification is output. That is, this is made possible by producing no output from the second port 9b. As electric leakage detection characteristics, a type that can detect only a ground fault of an alternating-current is "Type AC" and a type that can also detect a ground fault subjected to half-wave rectification is "Type A". As a test signal, a simulated waveform of "Type A" is also made possible by making the output of the second port 9b become Lo.

As described above, since the ground fault interrupter according to Embodiment 1 includes a zero-phase current transformer for detecting a leakage current flowing through alternating-current electric circuits, a sensing resistor that converts a secondary-side output current of the zero-phase current transformer into a voltage, a signal detection circuit that takes in the voltage generated in the sensing resistor by performing A/D conversion and outputs a tripping signal or an alarm signal if a detected voltage is greater than or equal to a given voltage, an electric leakage test circuit that outputs two or more electric leakage test signals having different phases, an alarm output circuit that operates by receiving the tripping signal or the alarm output signal, and a trigger circuit that outputs the electric leakage test signals, the ground fault interrupter can output, in a simplified manner, an electric leakage test signal which is used in a test operation, a waveform close to an actual waveform, not a simple rectangular waveform, which makes it possible to, even when a waveform whose phase is indeterminate, such as a waveform flowing through a thyristor circuit, for example, is input, perform a check as to whether the ground fault interrupter operates normally by outputting a simulated signal waveform from the electric leakage test circuit.

### Embodiment 2.

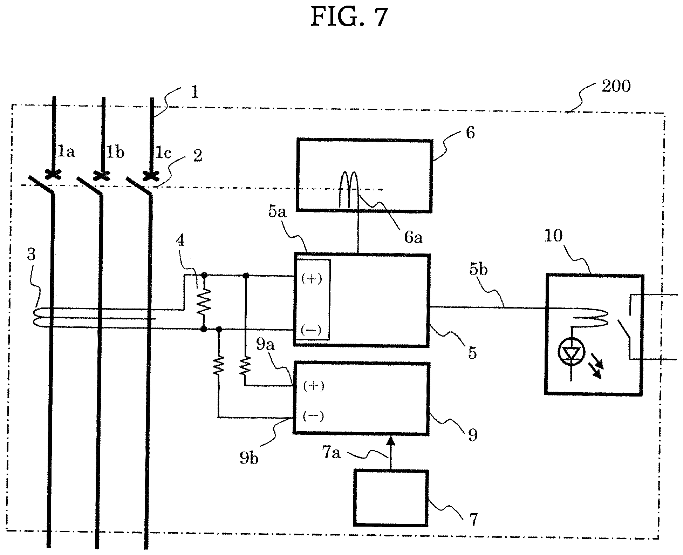

Next, a ground fault interrupter according to Embodiment 2 of this invention will be described. Fig. 7 is a block diagram depicting the ground fault interrupter according to Embodiment 2, and the same portions as those of Embodiment 1 or portions corresponding to those of Embodiment 1 will be identified with the same reference signs and the detailed explanations thereof will be omitted.

A ground fault interrupter 200 according to Embodiment 2 is configured so that, as a method for outputting a simulated waveform of a leakage current from the electric leakage test circuit 9, a voltage signal is applied directly to the A/D converter circuit 5a of the signal detection circuit 5.

By connecting the electric leakage test circuit 9 to the A/D converter circuit 5a of the signal detection circuit 5 and applying a voltage signal of the electric leakage test circuit 9 to the A/D converter circuit 5a of the signal detection circuit 5, a signal that imitates an alternating-current waveform is output. As a result, the voltage signal of the electric leakage test circuit 9 is taken in by the signal detection circuit 5 as digital data in the A/D converter circuit 5a of the signal detection circuit 5 and is provided with a waveform exceeding a prescribed leakage current value. Then, the signal detection circuit 5 excites the tripping coil 6a by outputting the tripping signal and operates the tripping circuit 6. This makes it possible to perform a test operation of interrupting the alternating-current electric circuits 1 by opening the switching contacts 2. Since the other configurations and operations are similar to those of Embodiment 1, the explanations thereof will be omitted.

Also in this ground fault interrupter 200 according to Embodiment 2, the same effects as those of the ground fault interrupter 100 according to Embodiment 1 can be obtained.

While Embodiments 1 and 2 of this invention have been described above, this invention allows the embodiments to be combined arbitrarily and to be modified or omitted as appropriate within the scope of the appended claims.

## Claims

1. A ground fault interrupter (100 or 200) comprising:
a zero-phase current transformer (3) having a secondary winding that outputs a current proportional to a leakage current flowing through alternating-current electric circuits (1);
a sensing resistor (4) that is provided in addition to the zero-phase current transformer (3) and converts the secondary-side output current of the zero-phase current transformer (3) into a voltage;
a signal detection circuit (5) that performs A/D conversion on the voltage generated by the sensing resistor (4) and outputs a tripping signal or an alarm signal if the detected voltage on which the A/D conversion has been performed is greater than or equal to a given voltage;
an alarm output circuit (10) that operates by receiving the tripping signal or the alarm output signal;
a trigger circuit (7) that outputs a trigger signal (7a); and
an electric leakage test circuit (9) that outputs two or more electric leakage test signals having different phases in response to receipt of the trigger signal (7a),
wherein the two or more electric leakage test signals having different phases, which are output from the electric leakage test circuit (9), are directly or indirectly input to the signal detection circuit (5), and after having being subject to A/D conversion are suitable to cause the signal detection circuit (5) to perform an operation which is identical to the operation that is performed when a leakage current is generated even when a leakage current is not generated in the alternating-current electric circuits (1).

2. The ground fault interrupter (100 or 200) according to claim 1, wherein
the signal detection circuit (5) incorporates an A/D converter circuit (5a) having a differential input function, and the two or more electric leakage test signals having different phases, which are output from the electric leakage test circuit (9), are directly or indirectly input to the A/D converter circuit (5a).

3. The ground fault interrupter (100) according to claim 2, wherein
the electric leakage test circuit (9) is connected to a tertiary winding (8) of the zero-phase current transformer (3) and can perform, even when a leakage current is not generated in the alternating-current electric circuits (1), an operation which is performed when a leakage current is generated.

4. The ground fault interrupter (200) according to claim 2, wherein
the electric leakage test circuit (9) is connected to the A/D converter circuit (5a) and can perform, even when a leakage current is not generated in the alternating-current electric circuits (1), an operation which is performed when a leakage current is generated.

5. The ground fault interrupter (100) according to claim 3, wherein
the electric leakage test circuit (9) includes a first port (9a) connected to one end of the tertiary winding (8) and a second port (9b) connected to another end of the tertiary winding (8).

6. The ground fault interrupter (200) according to claim 4, wherein
the electric leakage test circuit (9) includes a first port (9a) connected to one end of the sensing resistor (4) and a second port (9b) connected to another end of the sensing resistor (4).

7. The ground fault interrupter (100 or 200) according to any one of claims 1 to 6, wherein
phase control or waveform control can be performed on a signal which is output from the electric leakage test circuit (9) and a test signal which is generated by the phase control or the waveform control can also be set in accordance with a waveform for which an operation check is to be performed.

## Patentansprüche

1. Fehlerstromschutzschalter (100 oder 200), aufweisend:
einen Nullphasen-Stromwandler (3) mit einer Sekundärwicklung, die einen Strom ausgibt, der proportional zu einem durch elektrische Wechselstromkreise (1) fließenden Ableitungsstrom ist;
einen Messwiderstand (4), der zusätzlich zu dem Nullphasen-Stromwandler (3) vorgesehen ist und den sekundärseitigen Ausgangsstrom des Nullphasen-Stromwandlers (3) in eine Spannung wandelt;
eine Signaldetektionsschaltung (5), die eine A/D-Umsetzung an der von dem Messwiderstand (4) erzeugten Spannung durchführt und ein Auslösesignal oder
ein Alarmsignal ausgibt, wenn die detektierte Spannung, an der die A/D-Umsetzung durchgeführt wurde, größer oder gleich einer vorgegebenen Spannung ist;
eine Alarmausgabeschaltung (10), die in Folge des Empfangs des Auslösesignals oder des ausgegebenen Alarmsignals arbeitet;
eine Triggerschaltung (7), die ein Triggersignal (7a) ausgibt; und
eine Elektroableitung-Testschaltung (9), die als Reaktion auf den Empfang des Triggersignals (7a) zwei oder mehr Elektroableitung-Testsignale mit unterschiedlichen Phasen ausgibt,
wobei die zwei oder mehr Elektroableitung-Testsignale mit unterschiedlichen Phasen, die von der Elektroableitung-Testschaltung (9) ausgegeben werden,
direkt oder indirekt in die Signaldetektionsschaltung (5) eingegeben werden und, nachdem sie einer A/D-Umsetzung unterzogen wurden, dazu geeignet sind, die Signaldetektionsschaltung (5) zu veranlassen, eine Operation durchzuführen, die identisch mit der Operation ist, die durchgeführt wird,
wenn ein Ableitungsstrom erzeugt wird, selbst wenn in den elektrischen Wechselstromkreisen (1) kein Ableitungsstrom erzeugt wird.

2. Fehlerstromschutzschalter (100 oder 200) nach Anspruch 1, wobei die Signaldetektionsschaltung (5) eine A/D-Umsetzerschaltung (5a) mit einer Differentialeingangsfunktion enthält, und die zwei oder mehr elektrischen Elektroableitung-Testsignale mit unterschiedlichen Phasen, die von der Elektroableitung-Testschaltung (9) ausgegeben werden, direkt oder indirekt in die A/D-Umsetzerschaltung (5a) eingegeben werden.

3. Fehlerstromschutzschalter (100) nach Anspruch 2, wobei die Elektroableitung-Testschaltung (9) mit einer Tertiärwicklung (8) des Nullphasen-Stromwandlers (3) verbunden ist und auch dann, wenn in den elektrischen Wechselstromkreisen (1) kein Ableitungsstrom erzeugt wird, eine Operation durchführen kann, die durchgeführt wird, wenn ein Ableitungsstrom erzeugt wird.

4. Fehlerstromschutzschalter (200) nach Anspruch 2, wobei die Elektroableitung-Testschaltung (9) mit der A/D-Umsetzerschaltung (5a) verbunden ist und auch dann, wenn in den elektrischen Wechselstromkreisen (1) kein Ableitungsstrom erzeugt wird, eine Operation durchführen kann, die durchgeführt wird, wenn ein Ableitungsstrom erzeugt wird.

5. Fehlerstromschutzschalter (100) nach Anspruch 3, wobei die Elektroableitung-Testschaltung (9) einen ersten Anschluss (9a), der mit einem Ende der Tertiärwicklung (8) verbunden ist, und einen zweiten Anschluss (9b), der mit einem anderen Ende der Tertiärwicklung (8) verbunden ist, umfasst.

6. Fehlerstromschutzschalter (200) nach Anspruch 4, wobei die Elektroableitung-Testschaltung (9) einen ersten Anschluss (9a), der mit einem Ende des Messwiderstandes (4) verbunden ist, und einen zweiten Anschluss (9b), der mit einem anderen Ende des Messwiderstandes (4) verbunden ist, umfasst.

7. Fehlerstromschutzschalter (100 oder 200) nach einem der Ansprüche 1 bis 6, wobei an einem von der Elektroableitung-Testschaltung (9) ausgegebenen Signal eine Phasensteuerung oder Wellenformsteuerung durchgeführt werden kann, und ein durch die Phasensteuerung oder die Wellenformsteuerung erzeugtes Testsignal in Übereinstimmung mit einer Wellenform eingestellt werden kann, für die eine Betriebsprüfung durchgeführt werden soll.

## Revendications

1. Interrupteur de défaut à la masse (100 ou 200) comprenant :
un transformateur de courant de phase nulle (3) ayant un enroulement secondaire qui délivre en sortie un courant proportionnel à un courant de fuite s'écoulant à travers des circuits électriques à courant alternatif (1) ;
une résistance de détection (4) qui est prévue en plus du transformateur de courant de phase nulle (3) et convertit le courant de sortie côté secondaire du transformateur de courant de phase nulle (3) en une tension ;
un circuit de détection de signal (5) qui réalise une conversion A/N sur la tension générée par la résistance de détection (4) et délivre en sortie un signal de déclic ou un signal d'alarme si la tension détectée sur laquelle la conversion A/N a été réalisée est supérieure ou égale à une tension donnée ;
un circuit de sortie d'alarme (10) qui fonctionne en recevant le signal de déclic ou le signal de sortie d'alarme ;
un circuit à déclenchement (7) qui délivre en sortie un signal de déclenchement (7a) ; et
un circuit de test de fuite électrique (9) qui délivre en sortie deux ou plus signaux de test de fuite électrique ayant des phases différentes en réponse à la réception du signal de déclenchement (7a),
dans lequel les deux ou plus signaux de test de fuite électrique ayant des phases différentes, qui sont délivrés en sortie du circuit de test de fuite électrique (9), sont reçus en entrée directement ou indirectement dans le circuit de détection de signal (5), et après avoir été soumis à une conversion A/N sont aptes à faire réaliser au circuit de détection de signal (5) une opération qui est identique à l'opération qui est réalisée quand un courant de fuite est généré même quand un courant de fuite n'est pas généré dans les circuits électriques à courant alternatif (1).

2. Interrupteur de défaut à la masse (100 ou 200) selon la revendication 1, dans lequel
le circuit de détection de signal (5) incorpore un circuit convertisseur A/N (5a) ayant une fonction d'entrée différentielle, et les deux ou plus signaux de test de fuite électrique ayant des phases différentes, qui sont délivrés en sortie du circuit de test de fuite électrique (9), sont reçus en entrée directement ou indirectement dans le circuit convertisseur A/N (5a).

3. Interrupteur de défaut à la masse (100) selon la revendication 2, dans lequel le circuit de test de fuite électrique (9) est relié à un enroulement tertiaire (8) du transformateur de courant de phase nulle (3) et peut réaliser, même quand un courant de fuite n'est pas généré dans les circuits électriques à courant alternatif (1), une opération qui est réalisée quand un courant de fuite est généré.

4. Interrupteur de défaut à la masse (200) selon la revendication 2, dans lequel le circuit de test de fuite électrique (9) est relié au circuit convertisseur A/N (5a) et peut réaliser, même quand un courant de fuite n'est pas généré dans les circuits électriques à courant alternatif (1), une opération qui est réalisée quand un courant de fuite est généré.

5. Interrupteur de défaut à la masse (100) selon la revendication 3, dans lequel le circuit de test de fuite électrique (9) inclut un premier port (9a) relié à une extrémité de l'enroulement tertiaire (8) et un deuxième port (9b) relié à une autre extrémité de l'enroulement tertiaire (8).

6. Interrupteur de défaut à la masse (200) selon la revendication 4, dans lequel le circuit de test de fuite électrique (9) inclut un premier port (9a) relié à une extrémité de la résistance de détection (4) et un deuxième port (9b) relié à une autre extrémité de la résistance de détection (4).

7. Interrupteur de défaut à la masse (100 ou 200) selon l'une quelconque des revendications 1 à 6, dans lequel
une commande de phase ou une commande de forme d'onde peut être réalisée sur un signal qui est délivré en sortie du circuit de test de fuite électrique (9) et un signal de test qui est généré par la commande de phase ou la commande de forme d'onde peut aussi être réglé selon une forme d'onde pour laquelle le contrôle d'opération doit être réalisé.
